(19) Europäisches Patentamt / European Patent Office / Office européen des brevets

(11) **EP 4 206 132 B1**

(12) **EUROPEAN PATENT SPECIFICATION**

(45) Date of publication and mention
of the grant of the patent:
**29.01.2025  Bulletin 2025/05**

(21) Application number: **21861306.5**

(22) Date of filing: **17.08.2021**

(51) International Patent Classification (IPC):
*C01B 33/18* (2006.01)   *C08L 101/00* (2006.01)
*C08L 63/00* (2006.01)   *C08K 3/36* (2006.01)
*C01B 33/12* (2006.01)   *H01L 23/29* (2006.01)

(52) Cooperative Patent Classification (CPC):
(C-Sets available)
**H01L 23/295; C01B 33/12; C01B 33/18;**
**C08K 3/36;** C08K 2201/003; C08K 2201/006;
Y02E 30/30                                   (Cont.)

(86) International application number:
**PCT/JP2021/030002**

(87) International publication number:
**WO 2022/044878 (03.03.2022 Gazette 2022/09)**

(54) **AMORPHOUS SILICA POWDER AND RESIN COMPOSITION CONTAINING SAME**

AMORPHES SILICIUMDIOXIDPULVER UND HARZZUSAMMENSETZUNG DAMIT

POUDRE DE SILICE AMORPHE, ET COMPOSITION DE RÉSINE COMPRENANT CELLE-CI

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **25.08.2020   JP 2020141932**

(43) Date of publication of application:
**05.07.2023   Bulletin 2023/27**

(73) Proprietor: **Denka Company Limited**
**Tokyo 103-8338 (JP)**

(72) Inventors:
• **HATAYAMA, Yasuaki**
**Tokyo 103-8338 (JP)**
• **FUKUDA, Takashi**
**Tokyo 103-8338 (JP)**
• **SUGIMOTO, Atsuya**
**Tokyo 103-8338 (JP)**

(74) Representative: **Gulde & Partner**
**Patent- und Rechtsanwaltskanzlei mbB**
**Berliner Freiheit 2**
**10785 Berlin (DE)**

(56) References cited:
WO-A1-2020/100952      JP-A- 2001 199 713
JP-A- 2005 179 631      JP-A- 2018 190 746
JP-A- 2019 182 715      JP-A- 2019 182 715
US-A1- 2005 154 087

**(Cont. next page)**

(52) Cooperative Patent Classification (CPC): (Cont.)

C-Sets
**C08K 3/36, C08L 63/00**

**Description**

Technical Field

The present invention relates to an amorphous silica powder and a resin composition, specifically to an amorphous silica powder suitable as a filler of a liquid sealant, and a resin composition containing the amorphous silica powder.

Background Art

Recent reduction in size and weight and increase in performance of electronic devices have been realized by high integration of semiconductor elements, increase in pin counts and thickness reduction of semiconductor packages, and a high-density mounting technique on circuit boards. Recently, a surface-mounted package such as a quad flat package (QFP) that can be mounted at a high density has become the mainstream in place of a conventional pin insertion type package, and the demand for further reduction in size and thickness is increasing in the future.

Among such package mounting techniques, bare chip mounting techniques in which a semiconductor element is directly mounted on a circuit board have been increasingly used as mounting techniques for semiconductors and electronic devices required to be smaller, thinner, more lightweight, more densely mounted, delivered in a shorter time, and lower in cost. Methods of electrical connection between a bare-chip-mounted chip and a board include wire bonding, flip-chip bonding, and the like, and most of the mounted chips are sealed with a liquid sealant because of necessity of protection of the chip, filler reinforcement, and the like. Patent Document 3 discloses an amorphous silica powder having average particle diameter of 2 to 50 μm, Al content in terms of oxide of 500 to 3000 ppm, and Si content in terms of oxide of 99.0 mass% or more, average particle diameter of the amorphous silica powder in a particle size range of 3 to 60 μm which is a particle size range A of 5 to 50 μm, and Al content in terms of oxide of 500 ppm or less, and average particle diameter of the amorphous silica powder in a particle size range of 0.01 to 2 μm which is a particle size range B of 0.025 to 1.000 μm, and Al content in terms of oxide of 10000 to 50000 ppm. Patent Document 4 describes a metal oxide powder and a resin composition from which a liquid sealing material having excellent filling properties and storability can be produced. Patent Document 5 discloses a composite material including a thermoplastic resin, and silica glass spheres having a specific surface area of 0.5-10 m2/g.

Prior Art Documents

Patent Documents

Patent Document 1: JP 4244259 B2
Patent Document 2: JP 5265097 B2
Patent Document 3: JP 2019 182715 A
Patent Document 4: JP 2001 199713 A
Patent Document 5: US 2005/154087 A1

Disclosure of Invention

Problems to be Solved by the Invention

As described above, there is a trend for electronic devices to be reduced in size and thickness, and a resin composition used as a sealing agent is also required to have high fluidity.

The present invention has been made in view of the above, and an object thereof is to provide an amorphous silica powder that is suitable for obtaining a liquid sealant that exhibits superior fluidity, and a resin composition obtained by using the amorphous silica powder as a filler.

Means for Solving the Problems

The present inventors have succeeded in solving the above problems by appropriately adjusting the particle diameter distribution and the specific surface area of the amorphous silica powder.

That is, an aspect of the present invention provides an amorphous silica powder having a modal diameter within the range of 3.0 to 4.2 μm and a frequency of particles having particle diameters of less than 0.50 μm of 1.0% or more and 9% or less in the particle diameter frequency distribution and having a specific surface area of 3 to 10.5 $m^2/g$ having a cumulative oversize distribution of particles having particle diameters of 13 $\mu$m or more is 1 mass% or less, and having a frequency of particles having particle diameters of 0.50 to 1.83 $\mu$m is less than 2.0% in a peak having a maximum value within the range of 3.0 to 4.2 $\mu$m.

Furthermore, the amorphous silica powder of the present invention has a melting rate of 95% or more, and the total concentration of the uranium element and the thorium element is 10 ppb or less.

Another aspect of the present invention also provides a resin composition containing 10 to 90 mass% of the amorphous silica powder of the present invention.

The resin composition of the present invention is a liquid sealing agent.

Effects of the Invention

The resin composition containing the amorphous silica powder of the present invention is particularly useful as a liquid sealant because it exhibits superior viscosity characteristics.

Mode for Carrying Out the Invention

Hereinafter, the present invention will be described in more detail.

<Amorphous Silica Powder>

The specific surface area in the present invention is adjusted to a specific range by causing an amorphous silica powder having a modal diameter in the range of 3.0 to 4.2 $\mu$m in the particle diameter frequency distribution to contain a certain amount or more of particles having particle diameters of less than 0.50 $\mu$m. By this adjustment, the fluidity of a resin composition can be improved.

In the particle diameter frequency distribution of the amorphous silica powder of the present invention, the modal diameter is within the range of 3.0 to 4.2 $\mu$m. When the modal diameter in the particle diameter frequency distribution of the amorphous silica powder exceeds 4.2 $\mu$m, the above problem occurs. On the other hand, in the case of a powder having a small particle diameter as represented by a modal diameter in the particle diameter frequency distribution of less than 3.0 $\mu$m, the viscosity of a liquid sealant becomes too high, and the amount of the powder to be filled cannot be increased. The lower limit is 3.0 $\mu$m or more, or may be 3.2 $\mu$m or more. The upper limit is 4.2 $\mu$m or less. The modal diameter referred to herein is a particle diameter that exhibits the highest frequency in a particle diameter distribution obtained by a measurement method described later of a powder. In the case where the modal diameter of an amorphous silica powder as a raw material exceeds 4.2 $\mu$m, classification is performed to adjust the particle diameter distribution.

In addition, according to the present invention, when the frequency of particles having particle diameters of 0.50 to 1.83 $\mu$m is less than 2.0% in a peak having a maximum value within the range of 3.0 to 4.2 $\mu$m, the fluidity of the amorphous silica powder can be further enhanced. The frequency is more preferably 1.5% or less, 1.0% or less, or 0.5% or less or may be 0.0%. As a method for adjusting the frequency of particles having particle diameters of 0.50 to 1.83 $\mu$m to less than 2.0%, a conventionally known method can be adopted, and for example, a method of removing the coarse powder side and the fine powder side using a precision air classifier can be exemplified. The frequency of particles having particle diameters of 0.50 to 1.83 $\mu$m is a value obtained by a method for measuring a particle size distribution described later.

The number of frequency maximum peaks within the range of 3.0 to 4.2 $\mu$m in the particle diameter frequency distribution may be 1 from the viewpoint of obtaining the effect of the present invention, or there may be a plurality of peaks.

The frequency at the frequency maximum of a first peak showing the frequency maximum within the range of 3.0 to 4.2 $\mu$m in the particle diameter frequency distribution may be 5 vol% or more. The lower limit of the frequency may be 9 vol% or more. The upper limit of the frequency may be 20 vol% or less, 15 vol% or less, or 14 vol% or less.

In the amorphous silica powder of the present invention, the frequency of particles having particle diameters of less than 0.50 $\mu$m is 1.0% or more. By adding particles having particle diameters of less than 0.50 $\mu$m to particles having a modal diameter of 1 to 10 $\mu$m, the fluidity of the amorphous silica powder can be improved. The upper limit of the frequency of particles having particle diameters of less than 0.50 $\mu$m is 9% or less, or may be 7% or less, 5% or less, 4% or less, or 3% or less. The frequency of particles having particle diameters of less than 0.50 $\mu$m is a value obtained by measurement of a particle size distribution described later.

The frequency of particles having particle diameters of less than 0.50 $\mu$m preferably appears in the range of at least 0.10 $\mu$m to 0.50 $\mu$m from the viewpoint of enhancing the effect of the present invention. In addition, the entire frequency may not be in the range of 0.10 $\mu$m to 0.50 $\mu$m, but it is preferable that a frequency appear in the range of 0.1 to 0.3 $\mu$m.

In addition, in the frequency distribution of particle diameters, particles having particle diameters of less than 0.50

μm may be included in a peak different from a peak having a maximum value within the range of 3.0 to 4.2 μm. Examples thereof include the case where a peak having a maximum value within the range of 3.0 to 4.2 μm and a peak having a maximum value within the range of less than 0.50 μm are included and the case where a peak having a maximum value within the range of 3.0 to 4.2 μm and a peak having a maximum value within the range of 0.50 to less than 1 μm are included and where the peak having a maximum value within the range of 0.50 to less than 1 μm has a frequency of 1.0% or more within the range of less than 0.50 μm. In either case, the tails of the two peaks may or may not overlap with each other.

The particles having particle diameters of less than 0.50 μm may constitute a part of the peak having a maximum value within the range of 3.0 to 4.2 μm. For example, the peak having a maximum value within the range of 3.0 to 4.2 μm has a frequency of 1.0% or more within the range of less than 0.50 μm.

In addition, some particles having particle diameters of less than 0.50 μm may be included in the peak having a maximum value within the range of 3.0 to 4.2 μm, and others may be included in a peak different from the peak having a maximum value within the range of 3.0 to 4.2 μm. For example, a tail of the peak having a maximum value within the range of 3.0 to 4.2 μm has a frequency within the range of less than 0.50 μm, and there is a peak having a maximum value within the range of less than 0.50 μm.

In the present invention, it is preferable that the peak having a maximum value within the range of less than 0.50 μm be separated from the peak having a maximum value within the range of 3.0 to 4.2 μm. Even in this case, the tails of the respective peaks may or may not overlap with each other.

In addition, in the frequency distribution of particle diameters, in the case where particles having particle diameters of less than 0.50 μm are included in a peak different from the peak having a maximum value within the range of 3.0 to 4.2 μm, the number of peaks having frequencies within the range of less than 0.50 μm is not particularly limited, and the number of peaks may be 1 or more.

In addition, in the case where particles having particle diameters of less than 0.50 μm are included in a peak different from the peak having a maximum value within the range of 3.0 to 4.2 μm, the peak including the particles having particle diameters of less than 0.50 μm may or may not have a frequency within the range of 0.50 μm or more. In the case where there is a frequency within the range of 0.50 μm or more, it is preferable that 80% or more of the frequency is within the range of less than 0.50 μm.

In addition, in the case where the peak including the particles having particle diameters of less than 0.50 μm is a peak different from the peak having a maximum value within the range of 3.0 to 4.2 μm, the maximum value of the peak including the particles having particle diameters of less than 0.50 μm preferably appears within the range of more than 0.1 μm and 0.4 μm or less.

The specific surface area of the amorphous silica powder of the present invention is adjusted to 3 to 10.5 $m^2/g$. In the case where the specific surface area of the amorphous silica powder exceeds 10.5 $m^2/g$, the tendency of aggregation between fine particles increases, and the fluidity of the amorphous silica powder decreases. The upper limit may be 9 $m^2/g$ or less, or 8 $m^2/g$ or less. On the other hand, in the case where the specific surface area is less than 3 $m^2/g$, the amorphous silica powder is less likely to form a closest packed structure, so that the fluidity is reduced. The lower limit is preferably 4 $m^2/g$ or more preferably 5 $m^2/g$ or more.

In particular, in order to enhance the effect of the present invention, in the case where the peak including the particles having particle diameters of less than 0.50 μm is a peak different from the peak having a maximum value within the range of 3.0 to 4.2 μm, the specific surface area of the amorphous silica powder tends to decrease, but the specific surface area can be adjusted to a desired range by increasing the amount of the particles having particle diameters of less than 0.50 μm used, or the like.

In particular, in order to enhance the effect of the present invention, in the case where the frequency of particles having particle diameters of 0.50 to 1.83 μm in the peak having a maximum value within the range of 1 to 10 μm is less than 2.0%, the specific surface area of the amorphous silica powder tends to decrease, but the specific surface area can be adjusted to a desired range by increasing the amount of the particles having particle diameters of less than 0.50 μm used, or the like.

In the amorphous silica powder of the present invention, d10, d50, and d90 are not particularly limited. The value of d10 may be 0.5 to 4.0 μm. The value of d50 may be 3.5 to 7.0 μm. The value of d90 may be 4.0 to 9.0 μm. However, d10 is preferably 1.5 to 3.5 μm from the viewpoint of obtaining the effect of the present invention. The value of d50 is preferably 3.0 to 5.0 μm. The value of d90 is preferably 4.0 to 7.0 μm. Here, d10, d50, and d90 are the particle diameters at the cumulative values of 10%, 50%, and 90% in the particle diameter cumulative distribution, respectively. For the amorphous silica powder, the particle diameter distribution is obtained by a method to be described later and is represented by a volume distribution, and the refractive index is set to 1.5.

In the amorphous silica powder of the present invention, the cumulative oversize distribution of particles having particle diameters of 13 μm or more is 1 mass% or less. The cumulative oversize distribution may be 0 mass%. Since the number of coarse particles is small, it can be preferably used even in the case where the height between the mounting board and the chip is a narrow gap. Since the number of coarse particles is small, the amorphous silica powder can more easily form a closest packed structure, and the fluidity of the liquid sealant is improved.

The amorphous silica powder of the present invention may contain other components (additives and the like) other than the amorphous silica powder as long as the effect of the present invention is not impaired. For example, the other components may be 5 mass% or less, 3 mass% or less, 1 mass% or less, or 0 mass%.

In addition, it is preferable that the amorphous silica powder of the present invention do not contain the uranium element or the thorium element as other components depending on the application. In the case of use in a liquid sealant for sealing a semiconductor, the total of the concentration (content) of the uranium element and the concentration (content) of the thorium element is preferably 10 ppb or less from the viewpoint of reducing the failure occurrence rate of memory rewriting.

The amorphous silica powder of the present invention is optimally an amorphous silica powder produced by melting crystalline silica at a high temperature or synthesis in terms of bringing the thermal expansion coefficients of the semiconductor chip and the liquid sealant close to each other. Therefore, the melting rate of the amorphous silica powder of the present invention is preferably 95% or more.

The shape of the amorphous silica powder may be any of a spherical shape, a crushed shape, a needle shape, a flake shape, and the like, but a spherical amorphous silica powder is preferable from the viewpoint of filling the powder as much as possible to reduce the thermal expansion coefficient of the liquid sealant.

The amorphous silica powder of the present invention may be used in the form of a mixture with another inorganic filler. Here, the other inorganic filler includes a different type of filler such as alumina powder and magnesia powder, and an amorphous silica powder having a different particle size distribution.

The particle diameter frequency distribution of the amorphous silica powder of the present invention is measured using Coulter Particle Size Analyzer LS 13 320 (Coulter Beckman, Inc.). For the measurement conditions, a silica aqueous solution subjected to dispersing in advance with an ultrasonic homogenizer is put into the device, and analysis is performed under the condition of a refractive index of 1.5.

The production of the amorphous silica powder of the present invention can be carried out by mixing appropriate amounts of powders with different particle size compositions or by classification. From an industrial point of view, classification by a classifier is desirable, and the classification operation may be performed by either a dry method or a wet method. From the viewpoint of productivity and removal of coarse particles, it is preferable to use a dry precision air classifier.

<Resin Composition>

Next, the resin composition of the present invention will be described.

When the amorphous silica powder of the present invention is mixed with a resin, the amorphous silica powder of the present invention may be used singly or may be used in combination with a normal spherical or crushed powder. The blending ratio of the resin cannot be generally determined depending on the required characteristics of the resin composition but is selected in the range of 10 to 90 mass% as the mixing ratio of the amorphous silica powder of the present invention.

In the present invention, a compounding material and an additive other than the amorphous silica powder to be blended in the liquid sealant are not particularly limited, and those generally and conventionally used may be used as long as the effect of the present invention is not impaired. Other components (components other than the resin or the amorphous silica powder) may be 10 mass% or less, 5 mass% or less, 3 mass% or less, or 1 mass% or less. In addition, the application of the amorphous silica powder is not limited to the sealant, and the amorphous silica powder can also be used for filler applications for an adhesive, a paint, a tape, a resin substrate, and the like, an antiblocking material, and the like.

As a compounding material and an additive other than the amorphous silica powder to be blended in the liquid sealant, an epoxy resin that is in a liquid state at normal temperature can be exemplified as a typical example. The epoxy resin that can be used is not particularly limited as long as it has two or more epoxy groups in one molecule, and specific examples thereof include a bisphenol A epoxy resin, a bisphenol F epoxy resin, an alicyclic epoxy resin, a phenol novolac epoxy resin, a cresol novolac epoxy resin, and a naphthalenediol epoxy resin. These epoxy resins may be used singly or as a mixture of two or more thereof. In this case, in order to enhance the adhesion between the liquid epoxy resin and the amorphous silica powder of the present invention, better characteristics can be obtained by surface-treating the amorphous silica powder of the present invention with a silane surface treatment agent or just adding the agent without performing surface treatment.

The resin composition of the present invention may further appropriately contain as necessary a curing agent such as methyltetrahydrophthalic anhydride and methylhimic anhydride, a curing accelerator such as dicyandiamide and a high-melting-point imidazole compound, a silane coupling agent such as γ-glycidoxypropyltrimethoxysilane and γ-aminopropyltriethoxysilane, a pigment such as carbon black, a flame retardant such as a halogen compound and a phosphorus compound, a flame retardant aid such as antimony trioxide, and a low stress imparting agent such as rubber and a silicone compound.

Examples

<Preparation of Amorphous Silica Powder>

Amorphous silica powders of preparation examples of the present invention were prepared by the following procedure. As a raw material, commercially available amorphous silica was used. This raw material had one peak of the modal diameter in the range of 1 to 10 $\mu$m.

[Coarse Powder Classification]

First, the raw material amorphous silica powder was subjected to coarse powder classification in order to exclude large particle diameters. The cumulative oversize distribution of particles having particle diameters of 13 $\mu$m or more is shown in Table 1. In the examples, the cumulative oversize distribution of particles having particle diameters of 13 $\mu$m or more was 0.0 mass%.

[Fine Powder Classification]

Next, in some examples, the frequency of particles having particle diameters of 0.50 to 1.83 $\mu$m was adjusted by a method of removing the fine powder side using a precision air classifier. Table 1 shows the frequency of particles having particle diameters of 0.50 to 1.83 $\mu$m. In examples, the frequency at the modal diameter within the range of 1 to 10 $\mu$m was 9.3 to 13.6 vol%.

[Blending of Ultrafine Powder]

Next, in the examples, an amorphous silica powder having a smaller particle diameter (ultrafine powder having a particle size (median diameter) of 0.10 $\mu$m or 0.14 $\mu$m) than the amorphous silica powder obtained in the steps up to fine powder classification was blended at an internal addition ratio shown in Table 1. In this formulation, in each of the examples, a particle size with which the frequency appeared within the range of 0.1 to 0.3 $\mu$m was selected. In addition, blending was performed so that a peak different from a peak having a maximum value within the range of 1 to 10 $\mu$m appeared. In examples in which the particle size was 0.14 $\mu$m, the maximum value of the peak including particles having particle diameters of less than 0.50 $\mu$m was within the range of 0.1 to 0.3 $\mu$m.

<Preparation of Resin Composition>

A liquid epoxy resin (JER-807 (manufactured by Mitsubishi Chemical Corporation)) and silica of an example or a comparative example were mixed at a ratio of 35 : 65 (wt%).

<Evaluation of Amorphous Silica Powder and Resin Composition>

The characteristic values of the obtained amorphous silica powder and resin composition were measured according to the following. The measurement methods are as follows.

[Evaluation of Amorphous Silica Particles]

(1) Specific Surface Area

The BET theory was applied to the adsorption isotherm measured by the gas adsorption method to determine the specific surface area (BET value) (BET method).

(2) Particle Diameter

The particle diameter frequency distribution and the particle diameter cumulative distribution were measured using the Coulter method, which is not affected by the sample density.
The median diameter d ($\mu$m) of the ultrafine powder was determined from the BET value measured using the BET method by the following formula for silica particles (density 2.2 g/cm$^3$).

[Mathematical Formula 1]

Median diameter d = 6/((BET value)*2.2)

(3) Melting Rate

The melting rate in the present invention can be measured from the intensity ratio of a specific diffraction peak by performing X-ray diffraction analysis of a sample with the CuKα line at 2θ within the range of 26° to 27.5° using a powder X-ray diffractometer. That is, although crystalline silica has a main peak at 26.7°, fused silica does not have a main peak at this position. When fused silica and crystalline silica are mixed, a peak height at 26.7° corresponding to the ratio between the fused silica and the crystalline silica is obtained. Therefore, the mixing ratio of the crystalline silica (X-ray intensity of sample/X-ray intensity of crystalline silica) is calculated from the ratio of the X-ray intensity of the sample to the X-ray intensity of the crystalline silica standard sample, and the melting rate can be determined by the following formula.

Melting rate (%) = (1 - mixing ratio of crystalline silica) × 100          [Mathematical Formula 2]

(4) Content of Uranium Element and Thorium Element

The content of the uranium element and the thorium element was measured using an inductively coupled plasma mass spectrometer (ICP-MS).

[Evaluation of Resin Composition]

The viscosity of the resin composition after mixing was measured with a rheometer (shear rate: 1 (1/s), temperature: 30°C). The results are shown in Table 1.

[Evaluation Results]

Table 1 shows preparation conditions (powder classification conditions and composition) of each amorphous silica powder, powder characteristics, and physical property values of flow characteristics (viscosity) of a resin composition using each amorphous silica powder.

[Table 1]

|  | Example 1 | Example 2 | Example 3 | Example 4 | Example 5* | Example 6* | Example 7* | Comparative Example 1 |
|---|---|---|---|---|---|---|---|---|
| Coarse powder classification | ○ | ○ | ○ | ○ | ○ | ○ | ○ | ○ |
| Fine powder classification | ○ | ○ | ○ | - | - | - | - | - |
| Average particle diameter of ultrafine powder (μm) | 0.14 | 0.14 | 0.10 | 0.14 | 0.10 | 0.10 | 0.10 | - |
| Internal addition ratio of ultrafine powder (%) | 28 | 28 | 37 | 15 | 19 | 28 | 37 | 0 |
| Specific surface area (m²/g) | 5.9 | 6.1 | 10.1 | 4.9 | 6.1 | 8.1 | 9.9 | 4.7 |
| Melting rate (%) | 100.0 | 99.9 | 98.3 | 100.0 | 100.0 | 99.9 | 96.0 | 99.0 |
| Concentration of uranium + thorium (ppb) | 7.6 | 6.9 | 1.7 | 4.1 | 4.8 | 8.6 | 9.4 | 15.0 |

(continued)

| | Example 1 | Example 2 | Example 3 | Example 4 | Example 5* | Example 6* | Example 7* | Comparative Example 1 |
|---|---|---|---|---|---|---|---|---|
| Modal diameter ($\mu$m) | 3.9 | 3.9 | 3.5 | 3.2 | 3.2 | 3.2 | 3.2 | 3.9 |
| Frequency of particles having particle diameters of less than 0.50 $\mu$m (%) | 3.6 | 7.4 | 5.2 | 1.2 | 1.1 | 2.9 | 7.5 | 0.0 |
| Frequency of particles having particle diameters of 0.50 to 1.83 $\mu$m (%) | 0.0 | 0.3 | 0.0 | 1.0 | 2.0 | 2.4 | 4.7 | 6.7 |
| Cumulative oversize distribution of particles having particle diameters of 13 $\mu$m or more (mass%) | 0.0 | 0.0 | 0.0 | 0.0 | 0.0 | 0.0 | 0.0 | 0.0 |
| d10 ($\mu$m) | 2.8 | 2.3 | 2.6 | 2.4 | 2.3 | 2.2 | 1.9 3.2 | 2.5 |
| d50 ($\mu$m) | 4.1 | 4.0 | 3.9 | 3.4 | 3.4 | 3.3 | | 3.5 |
| d90 ($\mu$m) | 6.5 | 6.7 | 6.1 | 4.6 | 4.6 | 4.6 | 4.5 | 4.9 |
| Viscosity (Pa·s) | 33 | 43 | 48 | 51 | 52 | 66 | 74 | 85 |
| | *Examples not according to the invention | | | | | | | |

Industrial Applicability

The resin composition containing the amorphous silica powder of the present invention having a modal diameter within the range of 3.0 to 4.2 $\mu$m and a frequency of particles having particle diameters of less than 0.50 $\mu$m of 1.0% or more and 9% or less in the particle diameter frequency distribution and having a specific surface area of 3 to 10.5 m$^2$/g, having a cumulative oversize distribution of particles having particle diameters of 13 $\mu$m or more is 1 mass% or less, and having a frequency of particles having particle diameters of 0.50 to 1.83 $\mu$m is less than 2.0% in a peak having a maximum value within the range of 3.0 to 4.2 $\mu$m as a filler exhibits superior fluidity and is therefore suitable for a sealing agent for a semiconductor device.

**Claims**

1.   An amorphous silica powder having

a modal diameter within a range of 3.0 to 4.2 $\mu$m,
a frequency of particles having particle diameters of less than 0.50 $\mu$m of 1.0% or more and 9% or less in a particle diameter frequency distribution,
a specific surface area of 3 to 10.5 m$^2$/g,
a cumulative oversize distribution of particles having particle diameters of 13 $\mu$m or more being 1 mass% or less, and
a frequency of particles having particle diameters of 0.50 to 1.83 $\mu$m being less than 2.0% in a peak having a maximum value within the range of 3.0 to 4.2 $\mu$m.

**2.** The amorphous silica powder according to claim 1, wherein a melting rate is 95% or more.

**3.** The amorphous silica powder according to claim 1 or 2, wherein a total content of a uranium element and a thorium element is 10 ppb or less.

**4.** A resin composition comprising 10 to 90 mass% of the amorphous silica powder according to any one of claims 1 to 3.

**5.** The resin composition according to claim 4, used as a liquid sealant.

**Patentansprüche**

**1.** Amorphes Siliciumdioxidpulver, aufweisend:

einen Modaldurchmesser innerhalb eines Bereichs von 3,0 bis 4,2 $\mu$m,
eine Häufigkeit von Partikeln mit Partikeldurchmessern von weniger als 0,50 $\mu$m von 1,0 % oder mehr und 9 % oder weniger in einer Partikeldurchmesserhäufigkeitsverteilung,
eine spezifische Oberfläche von 3 bis 10,5 m$^2$/g,
wobei eine kumulative Übergrößenverteilung von Partikeln mit Partikeldurchmessern von 13 $\mu$m oder mehr 1 Masse-% oder weniger beträgt und
eine Häufigkeit von Partikeln mit Partikeldurchmessern von 0,50 bis 1,83 $\mu$m in einem Peak mit einem Maximalwert innerhalb des Bereichs von 3,0 bis 4,2 $\mu$m weniger als 2,0 % beträgt.

**2.** Amorphes Siliciumdioxidpulver nach Anspruch 1, wobei eine Schmelzrate 95 % oder mehr beträgt.

**3.** Amorphes Siliciumdioxidpulver nach Anspruch 1 oder 2, wobei ein Gesamtgehalt eines Uranelements und eines Thoriumelements 10 ppb oder weniger beträgt.

**4.** Harzzusammensetzung, die 10 bis 90 Masse-% des amorphen Siliciumdioxidpulvers nach einem der Ansprüche 1 bis 3 umfasst.

**5.** Harzzusammensetzung nach Anspruch 4, die als flüssiges Dichtmittel verwendet wird.

**Revendications**

**1.** Poudre de silice amorphe ayant

un diamètre modal dans une plage de 3,0 à 4,2 $\mu$m,
une fréquence de particules ayant des diamètres de particule inférieurs à 0,50 $\mu$m de 1,0 % ou plus et de 9 % ou moins dans une distribution de fréquence des diamètres de particules,
une surface spécifique de 3 à 10,5 m$^2$/g,
une distribution cumulative de surdimensionnement de particules ayant des diamètres de particule de 13 $\mu$m ou plus de 1 % en masse ou moins, et
une fréquence de particules ayant des diamètres de particule de 0,50 à 1,83 $\mu$m inférieure à 2,0 % dans un pic ayant une valeur maximale dans la plage de 3,0 à 4,2 $\mu$m.

**2.** Poudre de silice amorphe selon la revendication 1, dans laquelle le taux de fusion est de 95 % ou plus.

**3.** Poudre de silice amorphe selon la revendication 1 ou 2, dans laquelle une teneur totale d'un élément uranium et d'un élément thorium est de 10 ppb ou moins.

**4.** Composition de résine comprenant 10 à 90 % en masse de la poudre de silice amorphe selon l'une quelconque des revendications 1 à 3.

**5.** Composition de résine selon la revendication 4, utilisée en tant que produit d'étanchéité liquide.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4244259 B
- JP 5265097 B
- JP 2019182715 A
- JP 2001199713 A
- US 2005154087 A1